# EUROPÄISCHE PATENTSCHRIFT

(11) **EP 1 794 787 B1**
(45) Veröffentlichungstag und Bekanntmachung des Hinweises auf die Patenterteilung: **04.11.2009**
(21) Anmeldenummer: 05773768.6
(22) Anmeldetag: 08.08.2005
(51) Int. Cl.: H01L 21/48, H01L 23/495

(54) **LEITERRAHMEN FÜR EIN ELEKTRONISCHES BAUELEMENT UND VERFAHREN ZU DESSEN HERSTELLUNG**
LEAD FRAME FOR AN ELECTRONIC COMPONENT AND METHOD FOR THE PRODUCTION THEREOF
CADRE CONDUCTEUR POUR COMPOSANT ELECTRONIQUE, ET SON PROCEDE DE PRODUCTION

(30) Priorität: 28.09.2004 DE 102004047059
(43) Veröffentlichungstag der Anmeldung: 13.06.2007
(73) Patentinhaber: OSRAM Opto Semiconductors GmbH, 93055 Regensburg (DE)
(72) Erfinder: ARNDT, Karlheinz, 93077 Bad Abbach (DE); LIM, Huey Ling Rena, 93051 Regensburg (DE); BOGNER, Georg, 93138 Lappersdorf (DE); GRUBER, Stefan, 93077 Bad Abbach (DE); SCHNEIDER, Markus, 93152 Schönhofen (DE)
(74) Vertreter: Epping - Hermann - Fischer
(86) Internationale Anmeldenummer: PCT/DE2005/001402
(87) Internationale Veröffentlichungsnummer: WO 2006/034664

(56) Entgegenhaltungen:
- EP-A- 0 496 078
- US-E1- R E37 707
- PATENT ABSTRACTS OF JAPAN Bd. 011, Nr. 143 (E-504), 9. Mai 1987 (1987-05-09) -& JP 61 279161 A (FUJI ELECTRIC CO LTD), 9. Dezember 1986 (1986-12-09)
- PATENT ABSTRACTS OF JAPAN Bd. 013, Nr. 453 (E-831), 11. Oktober 1989 (1989-10-11) -& JP 01 175250 A (SONY CORP), 11. Juli 1989 (1989-07-11)

## Beschreibung

Die Erfindung betrifft einen Leiterrahmen nach dem Oberbegriff des Patentanspruchs 1 und ein Verfahren zu dessen Herstellung nach dem Oberbegriff des Patentanspruchs 9.

Als Leiterrahmen (Leadframe) bezeichnet man eine aus Blech ausgestanzte oder herausgeätzte Anordnung von metallischen Anschlussteilen für ein Halbleiter-Bauelement während des Herstellungsprozesses. Die einzelnen Anschlussteile bleiben zunächst in einem äußeren Bereich des Leiterrahmens miteinander verbunden, wodurch sie relativ zueinander in ihrer Position gehalten werden. Ein oder mehrere Halbleiterchips werden danach auf dafür vorgesehene Anschlussteile des Leiterrahmens aufgebracht und über so genannte Bonddrähte mit weiteren Anschlussteilen kontaktiert. Erst nachdem die Halbleiterchips und Teile des Leiterrahmens mit einem Gehäuse aus einer Kunststoffpress- oder -spritzmasse umgeben wurden, wird das Bauelement mit den Anschlussstreifen in einer gewünschten Länge aus dem Leiterrahmen herausgetrennt. Neben den Anschlusssteilen weisen Leiterrahmen häufig noch Haltestreifen auf, die mit in die Gehäuse eingegossen werden und der Fixierung des Bauelements in Haltevorrichtungen während des Herstellungsprozesses dienen. Falls die Haltestreifen in einer nur geringen Tiefe in das Gehäuse eingelassen sind, können sie auf einfache Weise am Ende des Herstellungsprozesses aus dem Gehäuse herausgezogen werden. Anderenfalls ist ein Abtrennen der Haltestreifen nahe des Gehäuses möglich, aber aufwändiger. Diese Möglichkeit zeigt D1 = JP 61279161. Um die Haltevorrichtungen möglichst einfach ausführen zu können, ist es erstrebenswert, dass die aus dem Gehäuse herausragenden Abschnitte der Anschlussteile, die im Folgenden als Anschlussstreifen bezeichnet werden, und die Haltestreifen in einer Ebene liegen. Zur Vereinfachung und Automatisierung des Herstellungsprozesses von HalbleiterBauelementen ist es zudem üblich, Leiterrahmen nicht für ein einzelnes Bauelement zu fertigen, sondern in Form von Endlosbändern für eine Vielzahl von gleichen Bauelementen vorzusehen. Ebenfalls ist bekannt, bereits vor Aufbringen des Halbleiterchips auf den Leiterrahmen an diesen schon Teile des Gehäuses anzuformen.

Problematisch kann das Konzept der Haltestreifen besonders bei sehr kleinen Gehäuseabmessungen werden. Ein Beispiel für ein Bauelement mit einem solchen Gehäuse stellen oberflächenmontierte, Licht emittierende Halbleiter-Bauelemente (LED Light Emitting Diode) dar. Die Gehäuse solcher Bauelemente sind typischerweise länglich mit zwei, gegebenenfalls axial aus dem Gehäuse heraustretenden Anschlussstreifen, wobei das Gehäuse nur unwesentlich breiter ist als die Anschlussstreifen. Um Haltestreifen realisieren zu können, die durch einfaches Herausziehen aus dem Gehäuse wieder entfernt werden können, müssen die Haltestreifen im Bereich des Gehäuses bereits von weiteren Anschlussteilen getrennt sein. Nach dem Stand der Technik führt das zu einem unvermeidbaren Stanz- oder Ätzspalt zwischen dem Ende der Haltestreifen und den angrenzenden Bereichen der Anschlussteile.

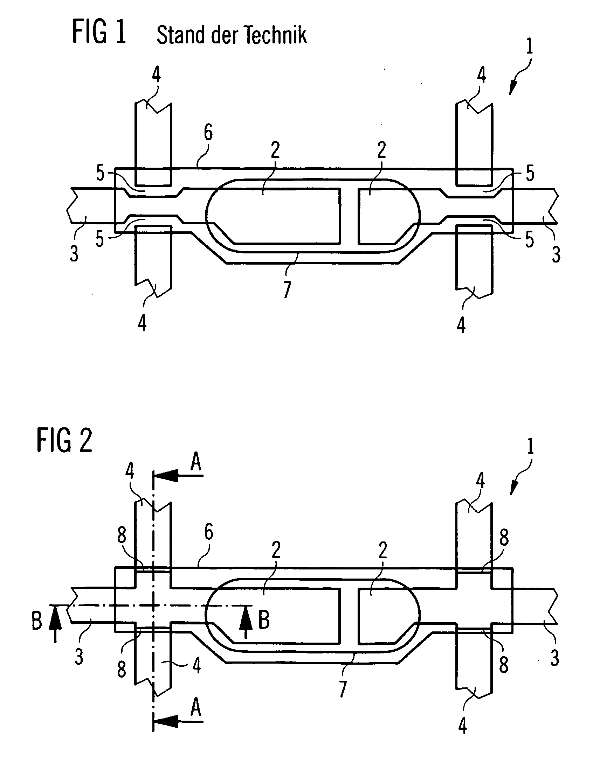

Figur 1 verdeutlicht diese bei Leiterrahmen nach dem Stand der Technik auftretende Problematik beispielhaft.

In Figur 1 der zentrale, inneren Teil eines metallischen Leiterrahmens 1 nach dem Stand der Technik in einer schematischen Schnittdarstellung wiedergegeben. Der Leiterrahmen 1 weist zwei elektrische Anschlussteile 2 auf, deren äußere Abschnitte als Anschlussstreifen 3 bezeichnet werden. Weiterhin sind vier Haltestreifen 4 vorgesehen, die von den Anschlussteilen 2 durch Stanz- bzw. Ätzspalte 5 getrennt sind. Weiterhin ist ein Gehäusekörper 6 vorhanden, der an den Leiterrahmen 1 angeformt ist. Der Gehäusekörper 6 weist eine zentrale Ausnehmung 7 auf, in dem im Falle eines vorgesehenen strahlungsemittierenden Bauelements beispielsweise ein Leuchtdiodenchip angeordnet werden kann.

Die in Figur 1 schematisch gezeigte Anordnung ist typisch für ein oberflächenmontierbares, Licht emittierendes Halbleiter-Bauelement, wie z. B. eine Miniatur-LED. Im gezeigten Beispiel ist an den Leiterrahmen 1 bereits der Gehäusekörper 6, beispielsweise aus Kunststoff, angeformt. Der Leiterrahmen 1 kann dabei beispielsweise aus Kupfer, das ggf. mit einem anderen Metall beschichtet ist, gefertigt sein. Im weiteren Herstellungsprozess des Bauelements wird durch die Ausnehmung 7 ein Halbleiterchip auf eines der elektrischen Anschlussteile 2 aufgesetzt und über einen Bonddraht mit dem anderen elektrischen Anschlussteil 2 verbunden. Anschließend wird die Öffnung 7 mit lichtdurchlässigem Kunstharz ausgegossen. Diese so genannte Pre-Mold-Technologie, bei der Teile des Gehäuses bereits vor dem Einsetzen des Halbleiterchips an einen Leiterrahmen angeformt werden, ist dem Fachmann für optoelektronische Bauelemente geläufig und wird von daher an dieser Stelle nicht näher erläutert.

Die elektrischen Anschlussstreifen 3 ragen axial aus dem länglichen Gehäusekörper 6 heraus. Diese Anschlussstreifen 3 werden im weiteren Herstellungsprozess des Bauelements auf eine vorgegebene Länge geschnitten und abgewinkelt. Diese Trim-and-Form genannten Herstellungsprozesse erfordern, das Bauelement in einer Haltevorrichtung zu fixieren. Diesem Zweck dienen die Haltestreifen 4. Sie ragen gerade so weit in den Gehäusekörper 6 hinein, dass sie, eingespannt in die Haltevorrichtung, die notwendigen Haltekräfte auf das Bauelement übertragen können und trotzdem durch leichte Zugkräfte aus dem Gehäusekörper 6 entfernt werden können, wenn sie nicht mehr benötigt werden. Typische Tiefen, die die Haltestreifen 4 dazu in den Gehäusekörper hineinragen, liegen im Bereich von 5/100 mm. Um durch leichte Zugkräfte entfernt werden zu können, müssen die Haltestreifen 4 im Leiterrahmen 1 von den Anschlussteilen 2 hinreichend getrennt sein.

Nach dem Stand der Technik erfolgt ein Trennen der von Haltestreifen vom Bauelement durch einen Stanz- oder Ätzprozess, welcher in einem Stanz- bzw. Ätzspalt 5 resultiert. Bei vorgegebenen Abmessungen des Gehäusekörpers 6 führt dieser Spalt 5 dazu, dass die Anschlussteile 2 im Bereich der Haltestreifen 4 verjüngt werden. Diese Verjüngung hat eine mechanische Instabilität des Leiterrahmens 1 zur Folge, die sich insbesondere in den Prozessschritten des Herstellungsprozesses negativ auswirken kann, in denen noch kein Gehäusekörper 6 an den Leiterrahmen 1 angeformt ist. Darüber hinaus führt eine Verjüngung der Anschlussteile 2 im Betrieb des Bauelements dazu, dass von dem Halbleiterchip produzierte Wärme nicht ausreichend über die Anschlussstreifen 3 abgeleitet werden kann.

Es ist daher die Aufgabe der vorliegenden Erfindung, einen Leiterrahmen anzugeben, der auch für ein sehr kleines Gehäuse Haltestreifen bereitstellt und die geschilderten Nachteile nicht aufweist. Gleichzeitig sollte die Anordnung von Haltestreifen und Anschlussstreifen zueinander eine einfache technische Ausgestaltung der im Herstellungsprozess eingesetzten Haltevorrichtungen erlauben.

Diese Aufgabe wird durch einen Leiterrahmen gemäß Patentanspruch 1 und durch ein Verfahren zur Herstellung eines solchen Leiterrahmens gemäß Patentanspruch 9 gelöst. Vorteilhafte Weiterbildungen und Ausgestaltungen sind Gegenstand der abhängigen Ansprüche.

Erfindungsgemäß ist vorgesehen, zwischen einem Haltestreifen und dem benachbarten Bereich des Anschlussteils einen Einschnitt vorzusehen, dessen Tiefe kleiner oder gleich der Dicke des Leiterrahmens ist und durch den zwischen dem Haltestreifen und dem Anschlussteil ein Parallelversatz ausgebildet ist. Ein solcher Einschnitt erlaubt das nachträgliche Entfernen des Haltestreifens aus dem Gehäuse des Bauelements durch leichte Zugkräfte. Vorteilhaft an einem Einschnitt gegenüber einem Stanz- oder Ätzspalt ist, dass ein Einschnitt ohne Materialentnahme und somit ohne zusätzlichen Platzbedarf ausgeführt werden kann, wodurch auf eine nachteilige Verjüngung der Anschlussteile bei Einführung der Haltestreifen verzichtet werden kann. Der durch den Einschnitt eingeführte Parallelversatz zwischen dem Haltestreifen und dem Anschlussteil wird erfindungsgemäß durch einen weiteren Parallelversatz zwischen den dem Haltestreifen benachbarten Bereichen des Anschlussteils und dem Anschlussstreifen ausgeglichen, sodass sich Haltestreifen und Anschlussstreifen wieder in einer Ebene befinden. Dadurch wird eine einfache Ausgestaltung der im Herstellungsprozesses eingesetzten Haltevorrichtungen und Spritzgusswerkzeuge sichergestellt.

In einer vorteilhaften Ausführungsform des Leiterrahmens sind die elektrischen Anschlussstreifen so ausgebildet, dass sie aus zwei einander gegenüberliegenden Seitenflächen aus einem für das Bauelement vorgesehenen und zum späteren Zeitpunkt an den Leiterrahmen anzuformenden Gehäusekörper herausragen. Besonders günstig ist dann, den mindestens einen Haltestreifen derart auszubilden, dass er durch eine dritte Seitenfläche des vorgesehenen Gehäusekörpers herausragt.

Die Tiefe des Einschnitts kann geringer sein als die Dicke des Leiterrahmens oder aber der Dicke des Leiterrahmens entsprechen. Im erstgenannten Fall erfolgt die Durchtrennung an der Stelle des Einschnitts beispielsweise in einem nachfolgenden Schritt des Herstellungsprozesses.

Es ist bevorzugt, dass entweder pro Anschlussstreifen mindestens zwei Haltestreifen vorgesehen sind, die auf einander gegenüberliegenden Seiten des vorgesehenen Gehäusekörpers angeordnet sind und sich in einer besonders günstigen Ausführungsform exakt gegenüberliegen. Alternativ sind für das elektronische Bauelement mindestens zwei Haltestreifen vorgesehen, die auf einander gegenüberliegenden Seiten des vorgesehenen Gehäusekörpers angeordnet sind.

In einer vorteilhaften Ausführungsform ist eine Vielzahl solcher Leiterrahmen in Form eines Endlosbandes zusammenhängend ausgebildet und für die maschinelle und automatisierte Massenfertigung einer Vielzahl von elektronischen Bauelementen vorgesehen. Für diese Ausführungsform erweist sich der erfindungsgemäße weitere Parallelversatz zwischen dem dem Haltestreifen benachbarten Bereich des Anschlussteils und dem elektrischen Anschlussstreifen als besonders vorteilhaft. Würden Haltestreifen und elektrische Anschlussstreifen nicht in einer Ebene liegen, würde die dadurch im Leiterrahmen eingeführte mechanische Verspannung, insbesondere bei einer Ausführung als Endlosband, zu Verwerfungen führen.

In einer weiteren Ausführungsform ist an den Leiterrahmen ein Gehäusekörper oder Teile eines Gehäusekörpers angeformt, was typischerweise in einem Spritzgussverfahren geschieht. Es handelt sich hierbei dann um so genannte vorgehäuste (premolded) Leiterrahmen.

Ein bevorzugtes Verfahren zur Herstellung eines Leiterrahmens gemäß der Erfindung ist **dadurch gekennzeichnet, dass** der elektrische Anschlussstreifen gegenüber dem dem Haltestreifen benachbarten Bereich des Anschlussteils durch einen Prägeprozess parallel versetzt wird. Bevorzugt ist, dass das Einschneiden und das weitere parallele Versetzen in einem kombinierten Kaltverformungsvorgang gleichzeitig ausgeführt werden.

Weitere Vorteile, bevorzugte Ausführungsformen und Weiterbildungen des Leiterrahmens und des Verfahrens ergeben sich aus den im Folgenden in Verbindung mit den Figuren näher erläuterten Ausführungsbeispielen.

Dabei zeigen:
Figur 1 eine schematische Schnittdarstellung eines Leiterrahmens mit Haltestreifen nach dem Stand der Technik,
Figur 2 eine schematische Schnittdarstellung eines Ausführungsbeispiels eines erfindungsgemäßen Leiterrahmens,
Figur 3 eine Schnittansicht durch ein Ausführungsbeispiel des erfindungsgemäßen Leiterrahmens gemäß Figur 2 entlang der Linie AA,
Figur 4 eine schematische Schnittansicht durch ein Ausführungsbeispiel des erfindungsgemäßen Leiterrahmens gemäß Figur 2 entlang der Linie BB,
Figur 5 eine schematische Schnittansicht durch ein weiteres Ausführungsbeispiel des erfindungsgemäßen Leiterrahmens gemäß Figur 2 entlang der Linie BB und
Figur 6 eine schematische Schnittdarstellung eines weiteren Ausführungsbeispiels des erfindungsgemäßen Leiterrahmens.

In den verschiedenen Ausführungsbeispielen und den zugehörigen Figuren 2 bis 4 und in der den Stand der Technik beschreibenden Figur 1 sind gleiche oder gleich wirkende Bestandteile jeweils mit den gleichen Bezugszeichen versehen. Die dargestellten Elemente der Figuren sind grundsätzlich nicht als maßstabsgetreu anzusehen. Vielmehr können sie zum besseren Verständnis teilweise übertrieben groß und in nicht der Wirklichkeit entsprechenden Größenverhältnissen zueinander dargestellt sein.

Figur 1, die den zentralen, inneren Teil eines metallischen Leiterrahmens 1 nach dem Stand der Technik zeigt, ist weiter oben in der Beschreibung ausführlich beschrieben.

In Figur 2 ist in einer zu Figur 1 analogen Darstellung ein Ausführungsbeispiel eines erfindungsgemäßen Leiterrahmens 1 angegeben. Dass ein in Pre-Mold-Technologie vorbereiteter Leiterrahmen 1 dargestellt ist, ist lediglich beispielhaft und nicht erfindungswesentlich.

Der in Figur 2 gezeigte Leiterrahmen unterscheidet sich von dem Leiterrahmen nach dem Stand der Technik darin, dass statt der Stanz- bzw. Ätzspalte 5 zwischen den Haltestreifen 4 und den Anschlussteilen 2 jeweils mindestens ein Einschnitt vorgesehen ist. Diese Einschnitte 8 sind so ausgeführt, dass sie im wesentlichen kein Material aus dem Leiterrahmen 1 entfernen. In der Ebene des Leiterrahmens 1 tritt somit kein Abstand zwischen den Anschlussteilen 2 und den Haltestreifen 4 auf. Ein Stanz- bzw. Ätzspalt 5, wie er bei Leiterrahmen nach dem Stand der Technik auftritt, entfällt und eine Verjüngung des Anschlussteils 2 wird verhindert.

In der Ebene senkrecht zum Leiterrahmen 1 sind die Haltestreifen 4 als Folge des Einschnitts von den Anschlussteilen 2 durch einen Parallelversatz voneinander ganz oder teilweise getrennt, wodurch sie durch leichte Zugkräfte aus dem Gehäuse 6 entfernbar sind, falls sie nicht mehr gebraucht werden. Ein solcher Einschnitt 8 kann in einem Stanzprozess in einfacher Weise durch zwei sich aufeinander zu bewegende, in der Ebene des Leiterrahmens 1 nicht beabstandete Kanten des Stanzwerkzeugs, die den Haltestreifen 4 gegenüber dem Anschlussteile 2 abscheren, erreicht werden. Die Einschnitte 8 können dabei in ihrer Tiefe derart ausgeführt werden, dass die Haltestreifen 4 gerade noch mit den Anschlussteilen 2 verbunden sind, aber nach Aufbringen von Zugkräften leicht abgetrennt werden können. Genauso gut ist aber möglich, die Einschnitte 8 so tief auszuführen, dass die Haltestreifen 4 bereits vollständig von den Anschlussteilen 2 abgetrennt sind.

Der durch die Einschnitte 8 hervorgerufene Parallelversatz zwischen den Haltestreifen 4 und den Anschlussteilen 2 würde ohne weitere Maßnahmen dazu führen, dass die Anschlussstreifen 3 und die Haltestreifen 4 nicht mehr in einer Ebene liegen. Ein Leiterrahmen mit solchen Eigenschaften erschwert den weiteren Herstellungsprozess. Wenn die Haltestreifen 4 und die Anschlussstreifen 3 nicht in einer Ebene liegen, werden sämtliche Haltevorrichtungen, die im Laufe des Herstellungsprozesses eingesetzt werden, unnötig verkompliziert. Ebenso werden die Spritzgusswerkzeuge, die zum Anformen des Gehäusekörpers eingesetzt werden, aufwändiger. Werden dagegen die Haltestreifen 4 und die Anschlussstreifen 3 an der Schnittlinie wieder in eine Ebene zurückgedrückt, treten im Leiterrahmen starke innere Verspannungen auf, da der Leiterrahmen an den Schnittlinien lateral leicht gedehnt wird. Insbesondere in einer Ausführung als Endlosband, geeignet zur Aufnahme einer Vielzahl von gleichen Bauelementen, führen diese inneren Verspannungen zu Verwerfungen des Leiterrahmens.

Aus diesem Grund ist erfindungsgemäß vorgesehen, den durch die Einschnitte 8 jeweils hervorgerufenen Parallelversatz durch je einen weiteren Parallelversatz zwischen den Anschlussstreifen 3 und den Bereichen der Anschlussteile 2, die unmittelbar den Haltestreifen 4 benachbart sind, auszugleichen.

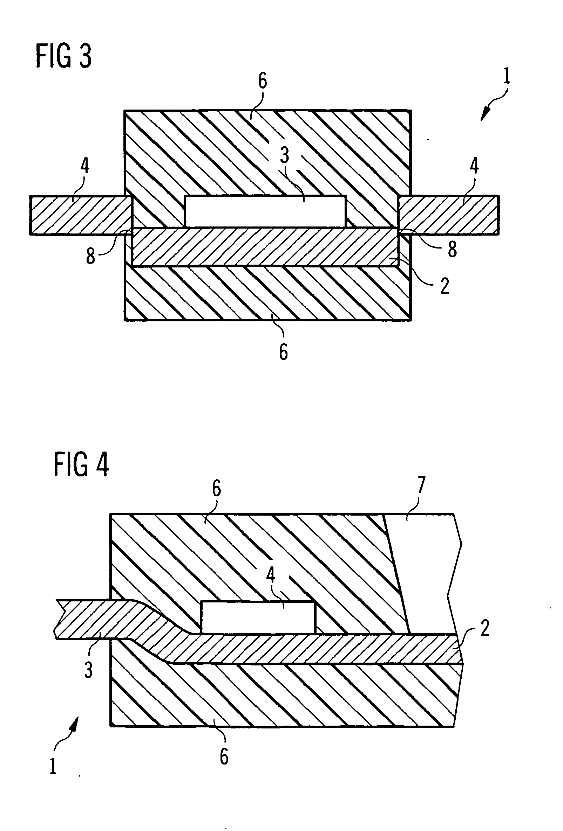

Figur 3 zeigt eine Schnittansicht des erfindungsgemäßen Leiterrahmens 1 mit dem angeformten Gehäusekörper 6 entlang der in Figur 2 dargestellten Schnittlinie AA. In der Figur ist deutlich der Parallelversatz zwischen den seitlich aus dem Gehäusekörper 6 herausragenden Haltestreifen 4 und den angrenzenden Bereichen der Anschlussteile 2, hervorgerufen durch die Einschnitte 8, zu sehen. Im gezeigten Beispiel sind die Einschnitte in einer Tiefe erfolgt, die geringfügig kleiner ist als die Dicke des Leiterrahmens 1, wodurch die Haltestreifen 4 nicht vollständig von den elektrischen Anschlussteilen 2 abgetrennt sind. Weiterhin ist deutlich zu erkennen, dass der nach vorne aus der Bildebene herausragende Anschlussstreifen 3 ebenfalls einen Parallelversatz zum Anschlussteil 2 aufweist, sodass der Anschlussstreifen 3 und die Haltestreifen 4 in einer Ebene liegen.

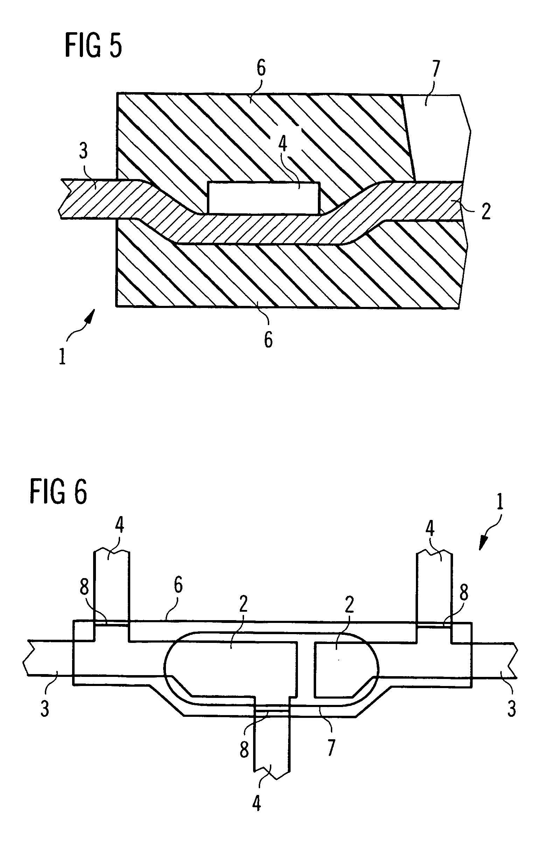

Die Figuren 4 und 5 zeigen schematische Schnittdarstellungen entlang der in Figur 2 gezeigten Linie BB für zwei verschiedene Ausführungsbeispiele des Leiterrahmens mit angeformtem Gehäusekörper 6. Beiden Ausführungsbeispielen ist gemeinsam, dass die Haltestreifen 4 in derselben Ebene liegen wie der links gezeigte Anschlussstreifen 3.

Im Ausführungsbeispiel von Figur 4 besteht ein Parallelversatz zwischen dem Anschlussstreifen 3 sowie dem gesamten Rest des Anschlussteils 2. Dies hat zur Folge, dass auch der innerhalb der Öffnung 7 liegende und als Chipträger dienende Bereich des Anschlussteils 2 außerhalb der ursprünglichen Ebene des Leiterrahmens 1 liegt.

In der alternativen Ausführungsform von Figur 5 sind dagegen zwei Prägekanten vorgesehen, sodass nur der direkt an die Haltestreifen 4 angrenzende Bereich der Anschlussteile 2 außerhalb der ursprünglichen Ebene des Leiterrahmens 1 liegt. Beide Ausführungsformen weisen die erfindungsgemäßen Vorteile auf, die Ausführungsform in Figur 4 ist allerdings stanztechnisch einfacher zu bewerkstelligen.

Figur 6 zeigt analog zu Figur 2 ein weiteres Ausführungsbeispiel des erfindungsgemäßen Leiterrahmens 1 mit angegossenem Gehäusekörper 6. Während bei dem in Figur 2 dargestellten Ausführungsbeispiel für jeden Anschlussstreifen 3 zwei symmetrisch angeordnete und sich gegenüberliegende Haltestreifen 4 vorgesehen sind, weist dieses Ausführungsbeispiel nur insgesamt drei Haltestreifen 4 auf. Zwei dieser Haltestreifen 4 sind wie zuvor in unmittelbarer Nähe zu den Anschlussstreifen 3 angeordnet, wohingegen der dritte Haltestreifen 4 auf der gegenüberliegenden Seite des Gehäuses 6 mittig angeordnet ist. Neben diesen beiden gezeigten möglichen Anordnungen der Haltestreifen 4 sind beliebige andere Kombinationen denkbar und im Sinne der Erfindung. Generell ist es vorteilhaft, dass Haltestreifen 4 an mindestens zwei sich gegenüberliegenden Seiten des Bauelements vorhanden sind. Darüber hinaus ist es vorteilhaft, wenn eine der beiden Seiten mit zwei, einen möglichst großen Abstand aufweisenden Haltestreifen 4 versehen ist. Eine Anordnung der Haltestreifen 4, die diesen Kriterien genügt, ermöglicht ein sicheres Fixieren des Bauelements in einer Haltevorrichtung.

## Patentansprüche

1. Leiterrahmen (1) für mindestens ein elektronisches Bauelement mit
- mindestens zwei elektrischen Anschlussteilen (2) mit jeweils mindestens einem elektrischen Anschlussstreifen (3) und
- mindestens einem Haltestreifen (4) benachbart zu einem der elektrischen Anschlussteile (2),
wobei
- zwischen dem mindestens einen Haltestreifen (4) und dem benachbarten Bereich des Anschlussteils (2) ein Einschnitt (8) vorgesehen ist, dessen Tiefe kleiner oder gleich der Dicke des Leiterrahmens (1) ist und durch den zwischen dem Haltestreifen (4) und dem benachbarten Bereich des Anschlussteils (2) ein Parallelversatz ausgebildet ist, und
- zwischen dem dem Haltestreifen (4) benachbarten Bereich des Anschlussteils (2) und dem elektrischen Anschlussstreifen (3) ein weiterer Parallelversatz vorgesehen ist, derart, dass sich der Haltestreifen (4) und der elektrische Anschlussstreifen (3) in einer gemeinsamen Ebene befinden.

2. Leiterrahmen (1) nach Anspruch 1, bei dem die elektrischen Anschlussstreifen (3) derart ausgebildet sind, dass sie auf zwei einander gegenüberliegenden Seitenfläche aus einem für das Bauelement vorgesehenen und zu einem späteren Zeitpunkt an den Leiterrahmen (1) anzuformenden Gehäusekörper (6) herausragen.

3. Leiterrahmen (1) nach Anspruch 2, bei dem der mindestens eine Haltestreifen (4) derart ausgebildet ist, dass er durch eine dritte Seitenfläche des vorgesehenen Gehäusekörpers (6) in diesen hineinragt.

4. Leiterrahmens (1) nach einem der Ansprüche 2 oder 3, **dadurch gekennzeichnet, dass** pro Anschlussstreifen (3) mindestens zwei Haltestreifen (4) vorgesehen sind, die auf einander gegenüberliegenden Seiten des vorgesehenen Gehäusekörpers (6) angeordnet sind.

5. Leiterrahmen (1) nach Anspruch 4, **dadurch gekennzeichnet, dass** die mindestens zwei Haltestreifen (4) pro Anschlussstreifen (3) sich gegenüberliegen liegen.

6. Leiterrahmen (1) nach einem der Ansprüche 2 oder 3, **dadurch gekennzeichnet, dass** für das elektronische Bauelement mindestens zwei Haltestreifen (4) vorgesehen sind, die auf einander gegenüberliegenden Seiten des vorgesehenen Gehäusekörpers (6) angeordnet sind.

7. Leiterrahmen (1) nach einem der Ansprüche 1 bis 6, **dadurch gekennzeichnet, dass** an den Leiterrahmen (1) ein Gehäusekörper (6) oder Teile eines Gehäusekörpers (6) angeformt sind.

8. Leiterrahmen (1) nach einem der Ansprüche 1 bis 7, der als Endlosband ausgeführt ist und für eine Vielzahl von elektronischen Bauelementen vorgesehen ist.

9. Verfahren zur Herstellung eines Leiterrahmens (1) nach einem der Ansprüche 1 bis 8, **dadurch gekennzeichnet, dass** der elektrische Anschlussstreifen (3) gegenüber dem dem Haltestreifen (4) benachbarten Bereich des Anschlussteils (2)durch einen Kaltverformungsprozess parallel versetzt wird.

10. Verfahren nach Anspruch 9, **dadurch gekennzeichnet, dass** das Einschneiden zwischen den Haltestreifen (4) und dem dem Haltestreifen (4) benachbarten Bereich des Anschlussteils (2) und das parallele Versetzten der elektrische Anschlussstreifen (3) in einem kombinierten Vorgang gleichzeitig ausgeführt wird.

## Claims

1. Leadframe (1) for at least one electronic component comprising:
- at least two electrical connection parts (2) with in each case at least one electrical connection strip (3), and
- at least one holding strip (4) adjacent to one of the electrical connection parts (2),
wherein
- an incision (8) is provided between the at least one holding strip (4) and the adjacent region of the connection part (2), the depth of which incision is less than or equal to the thickness of the leadframe (1) and by means of which incision a parallel offset is formed between the holding strip (4) and the adjacent region of the connection part (2), and
- a further parallel offset is provided between that region of the connection part (2) which is adjacent to the holding strip (4) and the electrical connection strip (3), in such a way that the holding strip (4) and the electrical connection strip (3) are situated in a common plane.

2. Leadframe (1) according to Claim 1, in which the electrical connection strips (3) are formed in such a way that they project, on two mutually opposite side faces, from a housing body (6) that is provided for the component and is to be moulded onto the leadframe (1) at a later point in time.

3. Leadframe (1) according to Claim 2, in which the at least one holding strip (4) is formed in such a way that it penetrates into the provided housing body (6) through a third side face thereof.

4. Leadframe (1) according to either of Claims 2 and 3, **characterized in that** at least two holding stripes (4) are provided per connection strip (3), said holding strips being arranged on mutually opposite sides of the housing body (6) provided.

5. Leadframe (1) according to Claim 4, **characterized in that** the at least two holding strips (4) per connection strip (3) lie opposite one another.

6. Leadframe (1) according to either of Claims 2 and 3, **characterized in that** at least two holding strips (4) are provided for the electronic component, said holding strips being arranged on mutually opposite sides of the housing body (6) provided.

7. Leadframe (1) according to any of Claims 1 to 6, **characterized in that** a housing body (6) or parts of a housing body (6) is or are moulded onto the leadframe (1).

8. Leadframe (1) according to any of Claims 1 to 7, which is embodied as a continuous tape and is provided for a multiplicity of electronic components.

9. Method for producing a leadframe (1) according to any of Claims 1 to 8, **characterized in that** the electrical connection strip (3) is offset in a parallel fashion relative to that region of the connection part (2) which is adjacent to the holding strip (4), by means of a cold-forming process.

10. Method according to Claim 9, **characterized in that** the incision cutting between the holding strips (4) and that region of the connection part (2) which is adjacent to the holding strip (4) and the offsetting of the electrical connection strips (3) in a parallel fashion are performed simultaneously in a combined process.

## Revendications

1. Cadre conducteur (1) pour au moins un composant électronique comprenant
- au moins deux pièces de raccordement électrique (2) comprenant chacune au moins une bande de raccordement électrique (3) et
- au moins une bande de maintien (4) voisine de l'une des pièces de raccordement électrique (2),
- une entaille (8) étant prévue entre l'au moins une bande de maintien (4) et la zone voisine de la pièce de raccordement (2), dont la profondeur est inférieure ou égale à l'épaisseur du cadre conducteur (1) et par laquelle est formé un décalage parallèle entre la bande de maintien (4) et la zone voisine de la pièce de raccordement (2), et
- un autre décalage parallèle est prévu entre la zone de la pièce de raccordement (2) voisine de la bande de maintien (4) et la bande de raccordement (3) de telle sorte que la bande de maintien (4) et la bande de raccordement électrique (3) se trouvent dans un plan commun.

2. Cadre conducteur (1) selon la revendication 1, avec lequel les bandes de raccordement électrique (3) sont configurées de telle sorte qu'elles font saillie sur deux surfaces latérales opposées l'une à l'autre d'un corps de boîtier (6) prévu pour le composant et à surmouler à un moment ultérieur sur le cadre conducteur (1).

3. Cadre conducteur (1) selon la revendication 2, avec lequel l'au moins une bande de maintien (4) est configurée de telle sorte qu'elle pénètre dans le corps de boîtier (6) prévu à travers une troisième surface latérale de celui-ci.

4. Cadre conducteur (1) selon l'une des revendications 2 ou 3, **caractérisé en ce qu'**au moins deux bandes de maintien (4) sont prévues par bande de raccordement (3), lesquelles sont disposées sur les côtés opposés l'un à l'autre du corps de boîtier (6) prévu.

5. Cadre conducteur (1) selon la revendication 4, **caractérisé en ce que** les au moins deux bandes de maintien (4) par bande de raccordement (3) sont opposées l'une à l'autre.

6. Cadre conducteur (1) selon l'une des revendications 2 ou 3, **caractérisé en ce qu'**au moins deux mandes de maintien (4) sont prévues pour le composant électronique, lesquelles sont disposées sur les côtés opposés l'un à l'autre du corps de boîtier (6) prévu.

7. Cadre conducteur (1) selon l'une des revendications 1 à 6, **caractérisé en ce qu'**un corps de boîtier (6) ou des parties d'un corps de boîtier (6) sont surmoulés sur le cadre conducteur (1).

8. Cadre conducteur (1) selon l'une des revendications 1 à 7, lequel est réalisé sous la forme d'une bande sans fin et est prévu pour un grand nombre de composants électroniques.

9. Procédé de fabrication d'un cadre conducteur (1) selon l'une des revendications de 1 à 8, **caractérisé en ce que** la bande de raccordement électrique (3) est décalée parallèlement par un processus de façonnage à froid par rapport à la zone de la pièce de raccordement (2) voisine de la bande de maintien (4).

10. Procédé selon la revendication 9, **caractérisé en ce que** l'entaille entre la bande de maintien (4) et la zone de la pièce de raccordement (2) voisine de la bande de maintien (4) et le décalage parallèle de la bande de raccordement électrique (3) sont réalisés simultanément au cours d'une opération combinée.
